# EUROPEAN PATENT APPLICATION

(11) **EP 4 701 031 A1**
(43) Date of publication of application: **25.02.2026**
(21) Application number: 24917310.5
(22) Date of filing: 05.12.2024
(51) Int. Cl.: H02J 7/00, G01R 31/3842, G01R 19/165, H01M 10/44, H01M 10/42

(54) **CELL BALANCING METHOD AND BATTERY PACK MANAGEMENT SYSTEM USING SAME**

(30) Priority: 12.01.2024 KR 20240005557
(71) Applicant: LG Energy Solution, Ltd., Seoul 07335 (KR)
(72) Inventor: HONG, Junhyeon, Daejeon 34122 (KR); CHOI, Hodeuk, Daejeon 34122 (KR); JEON, Younghwan, Daejeon 34122 (KR)
(74) Representative: Plasseraud IP
(86) International application number: PCT/KR2024/019801
(87) International publication number: WO 2025/150714

(57) **Abstract**

A cell balancing method for a battery pack including a plurality of battery cells includes determining a balancing target cell that requires a cell balancing among the plurality of battery cells; measuring a first voltage for the balancing target cell and measuring a first pack current flowing in the battery pack; turning on a balancing switch connected to the balancing target cell; measuring a second voltage for the balancing target cell and measuring a second pack current flowing in the battery pack; determining a balancing current calculation method depending on the difference between the first pack current and the second pack current; calculating a balancing current using the first voltage and the second voltage when the difference between the first pack current and the second pack current is within a predetermined range; calculating the balancing current by using the voltage change amount due to the first voltage, the second voltage, and the internal resistance of the balancing target cell when the difference between the first pack current and the second pack current is outside a predetermined range; and estimating a state of charge (SOC) of the balancing target cell depending on the balancing current.

## Description

### [Technical Field]

### CROSS-REFERENCE TO RELATED APPLICATION

This application claims priority to and the benefit of Korean Patent Application No. 10-2024-0005557 filed with the Korean Intellectual Property Office on January 12, 2024, the entire contents of which are incorporated herein by reference.

The present disclosure relates to a cell balancing method and a battery pack management system applying the same.

### [Background Art]

A battery cell balancing is a method to reduce a voltage difference between a plurality of cells that occurs during a charge/discharge voltage behavior of the plurality of cells connected in series. A circuit capable of discharging the plurality of cells is implemented in a battery management system (hereinafter referred to as "BMS"), and the cells with relatively high voltage are selected and discharged for a certain period of time to reduce the voltage difference with respect to the low voltage cells. Unlike this passive cell balancing method, there is also an active cell balancing method that charges the energy of the cell being balanced to other cells. However, since the difficulty of implementing the BMS circuit for the active cell balancing method is high, the passive cell balancing method is mainly used for lithium-ion batteries.

When using a passive cell balancing method, the state of the charge of the battery is measured using a coulomb counting method, etc., but this has the problem that errors may occur depending on changes in a power usage environment, such as a battery deterioration.

### [Disclosure]

### [Technical Problem]

The present disclosure aims to provide a cell balancing method capable of estimating a SOC (State Of Charge) of the cell more accurately and a battery pack management system to which this method is applied.

### [Technical Solution]

A cell balancing method for a battery pack including a plurality of battery cells according to the present disclosure includes determining a balancing target cell that requires a cell balancing among the plurality of battery cells; measuring a first voltage for the balancing target cell and measuring a first pack current flowing in the battery pack; turning on a balancing switch connected to the balancing target cell; measuring a second voltage for the balancing target cell and measuring a second pack current flowing in the battery pack; determining a balancing current calculation method depending on the difference between the first pack current and the second pack current; calculating a balancing current using the first voltage and the second voltage when the difference between the first pack current and the second pack current is within a predetermined range; calculating the balancing current by using the voltage change amount due to the first voltage, the second voltage, and the internal resistance of the balancing target cell when the difference between the first pack current and the second pack current is outsidea predetermined range; and estimating a state of charge (SOC) of the balancing target cell depending on the balancing current.

The balancing current may be calculated based on the difference between the first voltage and the second voltage when the difference between the first pack current and the second pack current is within a predetermined range.

The cell balancing method may further include calculating a voltage change amount based on the difference between the first pack current and the second pack current, and the internal resistance of the balancing target cell when the difference between the first pack current and the second pack current is outside a predetermined range.

Calculating the voltage change amount may include calculating the voltage change amount by multiplying the difference between the first pack current and the second pack current by the internal resistance of the balancing target cell.

Calculating the balancing current when the difference between the first pack current and the second pack current is outside the predetermined range may include calculating the balancing current by dividing a value obtained by subtracting the second voltage from the first voltage and adding the voltage change amount by a balancing resistance, and the balancing resistance may form a discharge path with the balancing target cell when the balancing switch is turned on.

Determining the balancing target cell may include estimating the SOC of each of the plurality of battery cells, calculating an average value of the plurality of SOCs of the plurality of battery cells, and determining the battery cell having an SOC higher than a predetermined value based on the average value as the balancing target cell.

A battery pack management system including a plurality of battery cells may include a cell monitoring IC connected to both terminals of each of the plurality of battery cells and measuring the cell voltage of each of the plurality of battery cells; and a main control circuit that determines a balancing target cell that requires a cell balancing among the plurality of battery cells, and, if there is the balancing target cell, transmits a command to turn on a balancing switch connected to the balancing target cell to the cell monitoring IC, and determines a balancing current calculation method based on a difference between a first pack current flowing in the battery pack when the balancing switch is in an off state and a second pack current flowing in the battery pack when the balancing switch is in an on state, and the main control circuit may calculate a balancing current by using a first voltage for the balancing target cell measured when the balancing switch is in an off state and a second voltage for the balancing target cell measured when the balancing switch is in an on state when the difference between the first pack current and the second pack current is within a predetermined range, and calculate a balancing current by using the first voltage, the second voltage, and a voltage change amount due to the internal resistance of the balancing target cell when the difference between the first pack current and the second pack current is outside the predetermined range, and estimate a SOC (state of charge) of the balancing target cell depending on the balancing current.

The main control circuit may calculate the balancing current based on the difference between the first voltage and the second voltage when the difference between the first pack current and the second pack current is within a predetermined range.

The main control circuit may calculate the voltage change amount based on the difference between the first pack current and the second pack current, and the internal resistance of the balancing target cell when the difference between the first pack current and the second pack current is outside a predetermined range.

The main control circuit may calculate the voltage change amount by multiplying the difference between the first pack current and the second pack current by the internal resistance of the balancing target cell.

The battery pack management system may further include a balancing resistor that forms a discharge path with the balancing target cell when the balancing switch is turned on, and the main control circuit may calculate the balancing current by subtracting the second voltage from the first voltage, adding the voltage change amount, and dividing the result by balancing resistance of the balancing resistor when the difference between the first pack current and the second pack current is outside a predetermined range.

The main control circuit may estimate the SOC of each of the plurality of battery cells, calculates an average value of the plurality of SOCs of the plurality of battery cells, and determine the battery cell having an SOC higher than a predetermined value based on the average value as the balancing target cell.

### [Advantageous Effects]

The cell balancing method capable of considering the internal cell resistance in estimating the SOC (state of charge) of the cell and the battery pack management system to which this method is applied are provided.

### [Description of the Drawings]

FIG. 1 is a diagram illustrating a battery pack system according to one embodiment.
FIG. 2 is a diagram illustrating a cell balancing circuit according to one embodiment.
FIG. 3 is a diagram showing a cell balancing circuit when a switch is turned off according to one embodiment.
FIG. 4 is a diagram showing a cell balancing circuit when a switch is turned on according to one embodiment.
FIG. 5 is a flowchart illustrating a method for estimating a SOC of a cell based on a battery pack current according to one embodiment.
FIG. 6 is a flowchart illustrating a method for calculating a balancing current based on an internal cell resistance according to one embodiment.

### [Mode for Invention]

Exemplary embodiments described in the present specification and a configuration shown in the drawings are just the most preferable exemplary embodiment of the present disclosure, but are not limited to the spirit and scope of the present disclosure. Therefore, it should be understood that there may be various equivalents and modifications capable of replacing them at the time of filing of the present application.

In addition, in describing embodiments of the present specification, when it is determined that a detailed description of the well-known art associated with the present disclosure may obscure the gist of the present disclosure, it will be omitted. In addition, the attached drawings are only for easy understanding of exemplary embodiments disclosed in the present specification, and technical ideas disclosed in the present specification are not limited by the attached drawings, and it should be understood to include all modifications, equivalents, or substitutes included in the ideas and technical ranges of the present disclosure.

Terms including ordinal numbers such as first, second, and the like will be used only to describe various constituent elements, and are not to be interpreted as limiting these constituent elements. The terms are only used to differentiate one constituent element from other constituent elements.

Also, in this specification, it is to be understood that when one component is referred to as being "connected" or "coupled" to another component, it may be connected or coupled directly to another component or may be connected or coupled to another component with the other component intervening therebetween. On the other hand, in this specification, it is to be understood that when one component is referred to as being "connected or coupled directly" to another component, it may be connected or coupled to another component without the other component intervening therebetween.

It will be further understood that terms "comprises" and "have" used in the present specification specify the presence of stated features, numerals, steps, operations, constituent elements, parts, or a combination thereof, but do not preclude the presence or addition of one or more other features, numerals, steps, operations, constituent elements, parts, or a combination thereof.

Hereinafter, embodiments disclosed in this specification will be described in detail with reference to the attached drawings.

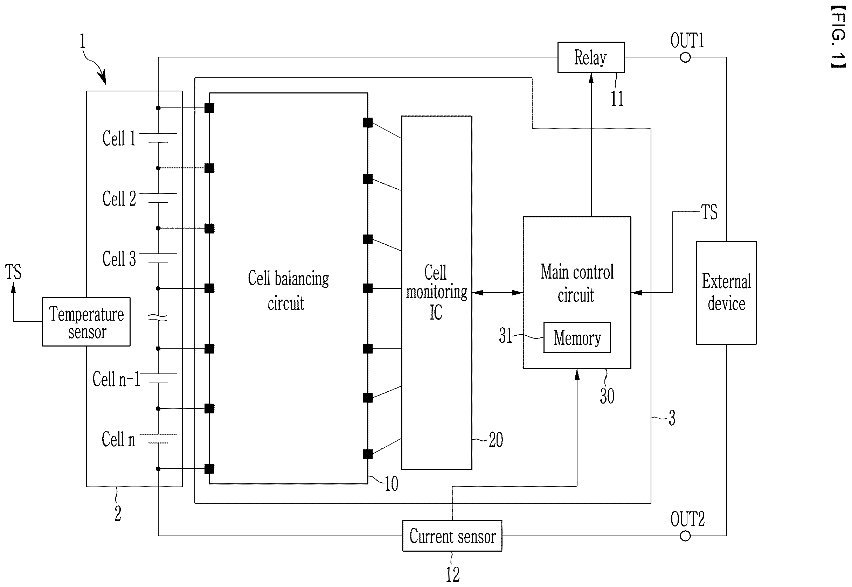

FIG. 1 is a diagram illustrating a battery pack system according to one embodiment.

Referring to FIG. 1, the battery pack management system 1 includes a battery pack 2, a BMS 3, a relay 11, a current sensor 12, and a temperature sensor 13.

Two output terminals OUT1 and OUT2 of the battery pack management system 1 are connected to the battery pack 2, the relay 11 is connected between the positive electrode of the battery pack 2 and the output terminal OUT1, and the current sensor 12 is connected between the negative electrode of the battery pack 2 and the output terminal OUT2. The temperature sensor 13 may be located at a predetermined location within the battery pack management system 1, for example, in an area adjacent to the battery pack 2, or may be physically coupled to the battery pack 2.

The battery pack 2 may supply a necessary power by connecting a plurality of battery cells in series/parallel. In FIG. 1, the battery pack 2 includes a plurality of battery cells Cell 1 to Cell n connected in series. The configurations and connection relationships between the configurations illustrated in Fig. 1 are merely examples, and the disclosure is not limited thereto.

The relay 11 controls the electrical connection between the battery pack 2 and an external device. When the relay 11 is turned on, the battery pack 2 and the external device are electrically connected and a charging or a discharging is performed, and when the relay 11 is turned off, the battery pack 2 and the external device are electrically separated. The external device may be a load or a charger.

The current sensor 12 is connected in series to the current path between the battery pack 2 and the external device. The current sensor 12 may measure the current flowing in the battery pack 2 (hereinafter referred to as "a battery pack current") and transmit a detection signal IS indicating the measurement result to the main control circuit 30. The battery pack current may be a charging current that charges the battery pack 2 or a discharging current supplied from the battery pack 2 to the external device.

The temperature sensor 13 can detect the temperature of the location and transmit information TS indicating the detected temperature to the main control circuit 30. The temperature sensor 13 is not limited to that shown in FIG. 1, and at least two may be provided to detect the temperature of the cells of the multiple batteries.

The BMS 3 includes a cell balancing circuit 10, a cell monitoring IC 20, and a main control circuit 30.

The cell balancing circuit 10 may be connected to each of the plurality of battery cells Cell 1 to Cell n and discharge the plurality of battery cells Cell 1 to Cell n according to a signal received from the cell monitoring IC 20.

The cell monitoring IC 20 may be electrically connected to the positive and negative electrodes of each of the plurality of battery cells Cell 1 to Cell n and measures the voltage of each of the plurality of battery cells Cell 1 to Cell n.

The cell monitoring IC 20 may transmit an information about the measured cell voltage of each of the multiple battery cells Cell 1 to Cell n to the main control circuit 30. Specifically, the cell monitoring IC 20 may measure the cell voltage of each of the plurality of battery cells Cell 1 to Cell n at a predetermined interval during a rest period in which no charging or discharging occurs, and transmit the measured cell voltage to the main control circuit 30.

The cell monitoring IC 20 may discharge the cell balancing target cell among the plurality of battery cells Cell 1 to Cell n through the cell balancing circuit 10 according to a cell balancing control signal transmitted from the main control circuit 30.

The main control circuit 30 estimates the SOC (state of charge) of each of the plurality of battery cells based on the cell voltage of each of the plurality of battery cells Cell 1 to Cell n received from the cell monitoring IC 20 during the rest period, calculates an average value of the plurality of SOCs of the plurality of battery cells Cell 1 to Cell n, and determines the battery cell having the SOC higher than a predetermined value based on the average value as a balancing target cell. The method for determining the balancing target cell of the main control circuit 30 is an example, and the method for determining the balancing target cell among the plurality of battery cells Cell1 to Celln may be implemented in various ways. For example, the main control circuit 30 may determine the reference voltage based on the multiple cell voltages of the multiple battery cells Cell1 to Celln instead of the SOC, and determine the battery cell having the cell voltage that is a predetermined value higher than the reference voltage as the balancing target cell.

Additionally, the main control circuit 30 can calculate the degree of change in battery pack current during the balancing period based on the detection signal IS received from the current sensor 12. The main control circuit 30 may calculate the balancing current, which is the current flowing in the cell balancing circuit 10, by considering the degree of the change in the battery pack current during the balancing period, and may estimate the SOC of the balancing target cell according to the balancing current.

The main control circuit 30 may store a monitoring information, such as the multiple cell voltage received from the cell monitoring IC 20 and the detection signal IS levels received from the current sensors 12, in the memory 31, etc.

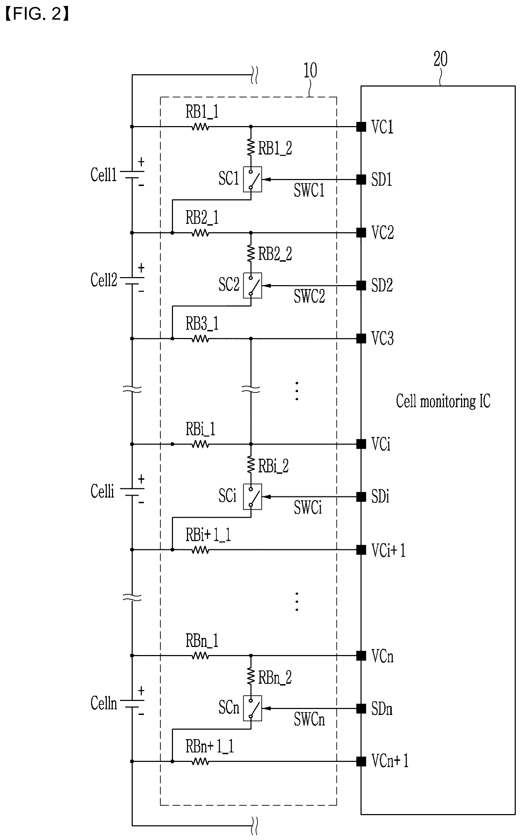

Hereinafter, the operation of the cell balancing circuit and the operation of the cell monitoring IC will be described with reference to FIG. 2 to FIG. 4.

FIG. 2 is a diagram illustrating a cell balancing circuit according to one embodiment.

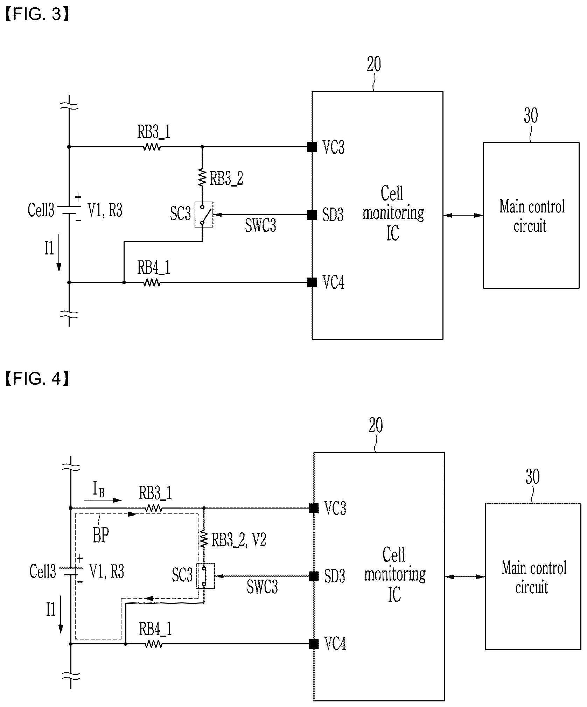

FIG. 3 is a diagram showing a cell balancing circuit when a switch is turned off according to one embodiment.

FIG. 4 is a diagram showing a cell balancing circuit when a switch is turned on according to one embodiment.

Referring to FIG. 2, the cell balancing circuit 10 includes a plurality of balancing resistors RB1_1 to RBn_1 and RB1_2 to RBn_2 and a plurality of balancing switches SC1 to SCn. The cell monitoring IC 20 includes a plurality of terminals VC1 to VC (n+1) for the cell voltage sensing and a plurality of terminals SD1 to SDn for controlling the balancing switch. (n is a natural number)

A balancing resistor RBi_1 is connected between the positive electrode of the cell Celli and the terminal VCi for cell voltage sensing, and a balancing resistor RBi+1_1 is connected between the negative electrode of the cell Celli and the terminal VC (i+1) for the cell voltage sensing (i is a natural number from 1 to n).

One end of the balancing resistor RBi_1 is connected to the positive electrode of the cell Cell i, the other end of the balancing resistor RBi_1 is connected to one end of the balancing resistor RBi_2 and the terminal VCi, and the other end of the balancing resistor RBi_2 is connected to one end of the balancing switch SCi. One end of the balancing resistor RBi+1_1 is connected to the negative electrode of the cell Celli and the other end of the balancing switch SCi, and the other end of the balancing resistor RB i+1_1 is connected to the terminal VC (i+1).

A switching signal SWCi for controlling the switching operation of the balancing switch may be provided to the balancing switch SCi from the terminal SDi for controlling the balancing switch.

The switching signal SWCi has an on level or an off level, and the balancing switch SCi may be turned on by the switching signal at the on level, and the balancing switch Sci may be turned off by the switching signal at the off level.

The cell monitoring IC 20 may measure the voltage between two adjacent terminals among the plurality of terminals VC1 to VC (n+1) and transmit the measured cell voltage to the main control circuit 30.

Referring to FIG. 3, a third cell Cell3, a balancing resistor RB3_1, a balancing resistor RB3_2, a balancing switch SC3, a balancing resistor RB4_1, a cell monitoring IC 20, and a main control circuit 30 are illustrated.

One end of the balancing resistor RB3_1 is connected to the positive electrode of the third cell Cell3, the other end of the balancing resistor RB3_1 is connected to one end of the balancing resistor RB3_2 and the terminal VC3, the other end of the balancing resistor RB3_2 is connected to one end of the balancing switch SC3, the other end of the balancing switch SC3 is connected to the negative electrode of the third cell Cell3 and one end of the balancing resistor RB4_1, and the other end of the balancing resistor RB4_1 is connected to the terminal VC4.

The balancing switch SC3 may perform a switching operation according to the switching signal SWC3 provided from the cell monitoring IC 20. The switching signal SWC3 for controlling the switching operation of the balancing switch may be provided from the terminal SD3 to the balancing switch SC3.

The switching signal SWC3 has an On level or an Off level, and the balancing switch SC3 may be turned on by the switching signal at the On level, and the balancing switch SC3 can be turned off by the switching signal at the Off level.

The positive voltage of the third cell Cell3 may be provided to the terminal VC3 through the balancing resistor RB3_1, and the negative voltage of the third cell Cell3 may be provided to the terminal VC4 through the balancing resistor RB4_1.

The cell monitoring IC 20 may measure the cell voltage of the third cell Cell3 according to the voltage difference between two terminals VC3 and VC4.

The cell monitoring IC 20 may transmit the first voltage V1 for the balancing target cell to the main control circuit 30 when the balancing switch SCi is in the off state. For example, when the balancing target cell is the third cell Cell3, the cell monitoring IC 20 may transmit the voltage of the third cell Cell3 measured when the balancing switch SC3 is in the off state as the first voltage V1 to the main control circuit 30. The cell monitoring IC 20 may transmit the voltage across the electrodes of the balancing resistor RB3_2 measured when the balancing switch SCi is on as a second voltage V2 to the main control circuit 30.

The main control circuit 30 may determine the internal resistance of the cell based on the cell voltage of each of the plurality of battery cells and the cell temperature measured from the temperature sensor 13. For example, the cell monitoring IC 20 may measure the voltage of the battery cell in the resting state where no charging or discharging is performed, and the main control circuit 30 may determine the OCV voltage based on the measured cell voltage and the internal resistance of the corresponding cell corresponding to the cell temperature. The main control circuit 30 stores a look-up table, a function, etc. that defines the relationship between the OCV, the temperature, and the internal resistance, and may use these to determine the internal resistance. However, the method for determining the internal resistance of the cell is not limited to this and may be implemented according to various known technologies.

Additionally, the main control circuit 30 may receive the battery pack current from the current sensor 12. For example, the main control circuit 30 may receive the detection signal IS from the current sensor 12 and determine the value of the battery pack current I1 flowing to the third cell Cell3 according to the detection signal IS.

Referring to FIG. 4, when the balancing switch SC3 is turned on, the third cell Cell3 is discharged along the discharge path BP consisting of the third cell Cell3, two balancing resistors RB3_1 and RB3_2, and the balancing switch SC3.

The cell is discharged as the balancing current IB flows along the discharge path BP. Specifically, the third cell Cell3 is discharged as the balancing current IB passes through two balancing resistors RB3_1 and RB3_2 in the discharge path BP.

At any point during the period in which the cell balancing is performed along the discharge path BP, the cell monitoring IC 20 may measure the second voltage V2, which is the voltage across the electrodes of the balancing resistor RB3_2. Any point in time is a predetermined period of a time from the start of the cell balancing, which may vary depending on the design.

At any point during the period in which the cell balancing is performed, the voltage of the one terminal of the balancing resistor RB3_2 may be provided to the terminal VC3, and the voltage at the other terminal of the balancing resistor RB3_2 may be provided to the terminal VC4.

The cell monitoring IC 20 may measure the second voltage V2 according to the voltage difference between two terminals VC3 and VC4. Additionally, the cell monitoring IC 20 may provide the second voltage V2 to the main control circuit 30.

The main control circuit 30 may determine the value of the battery pack current I2 flowing to the third cell Cell3 based on the detection signal IS provided from the current sensor 12 at any point during the period in which the cell balancing is performed.

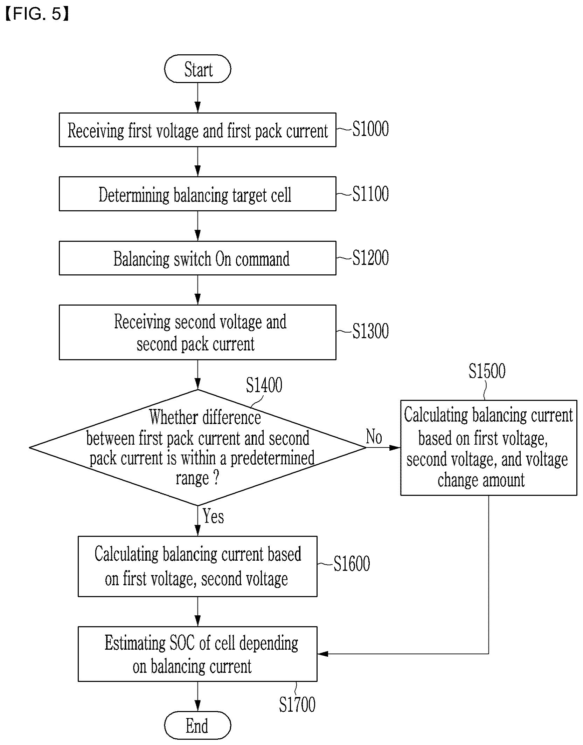

FIG. 5 is a flowchart illustrating a method for estimating the SOC of a cell based on a battery pack current according to one embodiment.

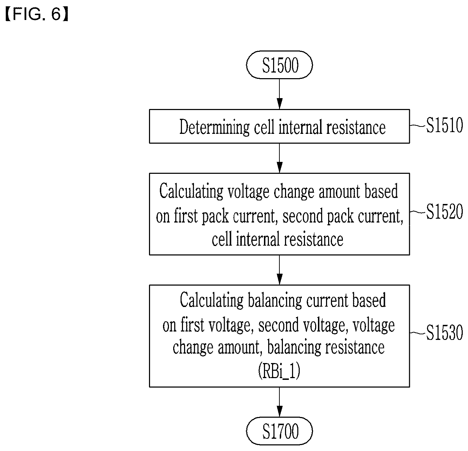

FIG. 6 is a flowchart illustrating a method for calculating balancing current based on internal cell resistance according to one embodiment.

Hereinafter, the main control circuit 30 will be described for calculating the balancing current IB and estimating the SOC of the cell based on the received information with reference to FIG. 5 and FIG. 6,

The main control circuit 30 may receive a first voltage V1 for the cell measured before the balancing operation from the cell monitoring IC 20 and may receive a battery pack current (hereinafter, a first pack current) flowing in the cell measured before the balancing operation from the current sensor 12 (S1000). The main control circuit 30 may also store this in memory 31, etc. Specifically, the main control circuit 30 may receive and store the cell voltage of each of the plurality of battery cells Cell1 to Celln received from the cell monitoring IC 20.

The main control circuit 30 may estimate the SOC of each of the plurality of battery cells based on the cell voltage of each of the plurality of battery cells Cell 1 to Cell n and determine the balancing target cell according to the SOC of each of the plurality of battery cells (S1100).

For example, the main control circuit 30 may calculate an average value of the plurality of the SOCs of the plurality of battery cells Cell 1 to Cell n and select the battery cell having the SOC higher than a predetermined value based on the average value as the balancing target cell.

When it is determined that the balancing target cell is selected and the balancing operation is necessary, the main control circuit 30 may transmit a balancing switch On command connected to the balancing target cell to the cell monitoring IC 20 (S1200).

The cell monitoring IC 20 may generate the switching signal SWCi of an on-level to turn on the balancing switch (e.g., SCi) corresponding to the balancing target cell (e.g., Celli) according to the ON command of the main control circuit 30, and transmit the signal to the balancing switch SCi.

The main control circuit 30 may receive a second voltage V2, which is the voltage across two terminals of the balancing resistor RBi_2, from the cell monitoring IC 20 and receive a detection signal IS from the current sensor 12 while the balancing switch is turned on and the cell balancing is performed along the discharge path BP. The main control circuit 30 may receive the battery pack current (hereinafter, a second pack current) flowing in the cell during the balancing operation based on the detection signal IS (S1300). The main control circuit 30 may also store the second voltage V2 and the battery pack current I2 in a memory, etc.

The main control circuit 30 may determine a method for calculating the balancing current by comparing the first pack current I1 and the second pack current I2 (S1400).

The main control circuit 30 may determine a method for calculating the balancing current value by comparing the difference between the first pack current I1 and the second pack current I2 with a predetermined range.

Specifically, the main control circuit 30 may calculate the balancing current by using the voltage change amount due to the first voltage V1, the second voltage V2 and the internal resistance of the balancing target cell (hereinafter, the cell internal resistance) when the difference between the first pack current I1 and the second pack current I2 is outside a predetermined range (S1500).

The main control circuit 30 may calculate the balancing current by using the first voltage V1 and the second voltage V2 when the difference between the first pack current I1 and the second pack current I2 is within a predetermined range (S1600).

A method for calculating the balancing current by the main control circuit 30 when the difference between the first pack current I1 and the second pack current I2 is outside the predetermined range is described with reference to FIG. 6.

The main control circuit 30 may determine the internal resistance of the balancing target cell when the difference between the first pack current **I1** and the second pack current I2 is outside the predetermined range (S1510).

The main control circuit 30 may determine the internal resistance of the cell based on the cell voltage of each of the plurality of battery cells and the cell temperature measured from the temperature sensor 13. For example, the cell monitoring IC 20 may measure the voltage of any battery cell in the resting state where no charging or discharging is performed, and the main control circuit 30 may determine the OCV voltage based on the measured cell voltage and the internal resistance of the corresponding cell corresponding to the cell temperature. The main control circuit 30 may store a look-up table, a function, etc. that defines the relationship between the OCV, the temperature, and the internal resistance, and may use these to determine the internal resistance. However, the method for determining the internal resistance of the cell is not limited thereto and may be implemented according to various known technologies.

The main control circuit 30 may calculate the voltage change amount based on the first pack current I1, the second pack current I2 and the cell internal resistance (S1520).

The voltage change amount refers to the difference in the voltages that occurs across the cells when the battery pack current changes. Specifically, the voltage change amount may be the difference between the cell voltage when the first pack current **I1** flows through the cell and the cell voltage when the second pack current I2 flows through the cell.

The main control circuit 30 may calculate the voltage change amount based on the difference between the first pack current **I1** and the second pack current I2, and the cell internal resistance.

Specifically, the main control circuit 30 may calculate the voltage change amount by multiplying the difference between the first pack current **I1** and the second pack current I2 by the cell internal resistance, and may store the voltage change amount in the memory, etc.

The main control circuit 30 may calculate the balancing current IB by using the first voltage V1, the second voltage V2, the voltage change amount, and the balancing resistor RBi_1 (S1530).

Specifically, the main control circuit 30 may calculate the balancing current IB by dividing the value obtained by subtracting the second voltage V2 from the first voltage V1 and adding the voltage change amount by the balancing resistor RBi_1 (S1530).

Referring to FIG. 3 and FIG. 4, the main control circuit 30 may calculate the voltage change amount of the third cell Cell3 by multiplying the difference between the first pack current **I1** and the second pack current I2 by the internal resistance R3 of the third cell Cell3, and the main control circuit 30 may calculate the value obtained by subtracting the second voltage V2 from the first voltage V1 and adding the voltage change amount of the third cell Cell3 and dividing the result by the balancing resistor RB3_1 as the balancing current IB.

The main control circuit 30 may calculate the balancing current IB by using only the first voltage V1 and the second voltage V2 because the influence of the cell internal resistance on the balancing current IB is small when the difference between the first pack current I1 and the second pack current I2 is within a predetermined range.

Specifically, the main control circuit 30 can calculate the balancing current IB based on the difference between the first voltage V1 and the second voltage V2 when the difference between the first pack current I1 and the second pack current I2 is within a predetermined range.

Referring to FIGS. 3 and 4, the main control circuit 30 may calculate the value obtained by dividing the difference between the first voltage V1 and the second voltage V2 by the balancing resistor RB3_1 as the balancing current IB.

The main control circuit 30 may estimate the SOC of the cell according to the balancing current IB (S1700).

The main control circuit 30 may estimate the SOC of the balancing target cell after the balancing operation by subtracting the discharge SOC of the battery cell (e.g., Celli) estimated according to the balancing current and the balancing operation time from the SOC of the battery cell (e.g., Celli) before the discharge according to a current integration method (a coulomb counting).

While this disclosure has been described in connection with what is presently considered to be practical exemplary embodiments, it is to be understood that the disclosure is not limited to the disclosed embodiments, but, on the contrary, is intended to cover various modifications and equivalent arrangements included within the spirit and scope of the appended claims.

## Claims

1. A cell balancing method for a battery pack including a plurality of battery cells, comprising:
determining a balancing target cell that requires a cell balancing among the plurality of battery cells;
measuring a first voltage for the balancing target cell and measuring a first pack current flowing in the battery pack;
turning on a balancing switch connected to the balancing target cell;
measuring a second voltage for the balancing target cell and measuring a second pack current flowing in the battery pack;
determining a balancing current calculation method depending on the difference between the first pack current and the second pack current;
calculating a balancing current using the first voltage and the second voltage when the difference between the first pack current and the second pack current is within a predetermined range;
calculating the balancing current by using the voltage change amount due to the first voltage, the second voltage, and the internal resistance of the balancing target cell when the difference between the first pack current and the second pack current is outside a predetermined range; and
estimating a state of charge SOC of the balancing target cell depending on the balancing current.

2. The cell balancing method of claim 1, wherein:
the balancing current is calculated based on the difference between the first voltage and the second voltage when the difference between the first pack current and the second pack current is within a predetermined range.

3. The cell balancing method of claim 1, further comprising:
calculating a voltage change amount based on the difference between the first pack current and the second pack current, and the internal resistance of the balancing target cell when the difference between the first pack current and the second pack current is outside a predetermined range.

4. The cell balancing method of claim 3, wherein:
calculating the voltage change amount includes
calculating the voltage change amount by multiplying the difference between the first pack current and the second pack current by the internal resistance of the balancing target cell.

5. The cell balancing method of claim 1, wherein:
calculating the balancing current when the difference between the first pack current and the second pack current is outside the predetermined range includes
calculating the balancing current by dividing a value obtained by subtracting the second voltage from the first voltage and adding the voltage change amount by a balancing resistance, and
the balancing resistance forms a discharge path with the balancing target cell when the balancing switch is turned on.

6. The cell balancing method of claim 1, wherein:
determining the balancing target cell includes
estimating the SOC of each of the plurality of battery cells, calculating an average value of the plurality of SOCs of the plurality of battery cells, and determining the battery cell having an SOC higher than a predetermined value based on the average value as the balancing target cell.

7. A battery pack management system including a plurality of battery cells, comprising:
a cell monitoring IC connected to both terminals of each of the plurality of battery cells and configured to measure the cell voltage of each of the plurality of battery cells; and
a main control circuit configured to
determine a balancing target cell that requires a cell balancing among the plurality of battery cells,
if there is the balancing target cell, transmit a command to turn on a balancing switch connected to the balancing target cell to the cell monitoring IC,
determine a balancing current calculation method based on a difference between a first pack current flowing in the battery pack when the balancing switch is in an off state and a second pack current flowing in the battery pack when the balancing switch is in an on state,
calculate a balancing current by using a first voltage for the balancing target cell measured when the balancing switch is in an off state and a second voltage for the balancing target cell measured when the balancing switch is in an on state when the difference between the first pack current and the second pack current is within a predetermined range,
calculate a balancing current by using the first voltage, the second voltage, and a voltage change amount due to the internal resistance of the balancing target cell when the difference between the first pack current and the second pack current is outside the predetermined range, and
estimates a state of charge SOC of the balancing target cell depending on the balancing current.

8. The battery pack management system of claim 7, wherein:
the main control circuit configured to calculate the balancing current based on the difference between the first voltage and the second voltage when the difference between the first pack current and the second pack current is within a predetermined range.

9. The battery pack management system of claim 7, wherein:
the main control circuit configured to calculate the voltage change amount based on the difference between the first pack current and the second pack current, and the internal resistance of the balancing target cell when the difference between the first pack current and the second pack current is outside a predetermined range.

10. The battery pack management system of claim 9, wherein:
the main control circuit configured to calculate the voltage change amount by multiplying the difference between the first pack current and the second pack current by the internal resistance of the balancing target cell.

11. The battery pack management system of claim 7, further comprising:
a balancing resistor configured to form a discharge path with the balancing target cell when the balancing switch is turned on, and
the main control circuit configured to calculate the balancing current by subtracting the second voltage from the first voltage, add the voltage change amount, and divide the result by balancing resistance of the balancing resistor when the difference between the first pack current and the second pack current is outside a predetermined range.

12. The battery pack management system of claim 7, wherein:
the main control circuit configured to estimate the SOC of each of the plurality of battery cells, calculate an average value of the plurality of SOCs of the plurality of battery cells, and determine the battery cell having an SOC higher than a predetermined value based on the average value as the balancing target cell.
